# EUROPÄISCHE PATENTSCHRIFT

(11) **EP 1 249 089 B1**
(45) Veröffentlichungstag und Bekanntmachung des Hinweises auf die Patenterteilung: **17.08.2005**
(21) Anmeldenummer: 01907452.5
(22) Anmeldetag: 16.01.2001
(51) Int. Cl.: H04B 17/00, G01R 13/02

(54) **VERFAHREN ZUM ANZEIGEN DER AMPLITUDENVERZERRUNGEN EINES ÜBERTRAGUNGSKANALS**
METHOD FOR DISPLAYING THE AMPLITUDE DISTORTIONS OF A TRANSMISSION CHANNEL
PROCEDE POUR AFFICHER LES DISTORSIONS D'AMPLITUDE D'UN CANAL DE TRANSMISSION

(30) Priorität: 20.01.2000 DE 10002337
(43) Veröffentlichungstag der Anmeldung: 16.10.2002
(73) Patentinhaber: Rohde & Schwarz GmbH & Co. KG, 81671 München (DE)
(72) Erfinder: BALZ, Christoph, 81543 München (DE); FEICHT, Wolfgang, 84539 Ampfing (DE)
(74) Vertreter: Körfer, Thomas, Dipl.-Phys.
(86) Internationale Anmeldenummer: PCT/EP2001/000436
(87) Internationale Veröffentlichungsnummer: WO 2001/054295

(56) Entgegenhaltungen:
- WO-A-99/17463
- DE-A- 4 233 222
- DE-A- 19 838 295
- US-A- 4 920 543
- MUELLER K ET AL: "APPLICATION OF AMPLITUDE HISTOGRAMS FOR QUALITY OF SERVICE MEASUREMENTS OF OPTICAL CHANNELS AND FAULT IDENTIFICATION" PROCEEDINGS OF THE EUROPEAN CONFERENCE ON OPTICAL COMMUNICATION, 1998, XP000887223
- TAKARA S H ET AL: "OPTICAL SIGNAL QUALITY MONITORING METHOD BASED ON OPTICAL SAMPLING" ELECTRONICS LETTERS,GB,IEE STEVENAGE, Bd. 34, Nr. 22, 1998, Seiten 2152-2154, XP000886728 ISSN: 0013-5194

## Beschreibung

Die Erfindung geht aus von einem Verfahren laut Oberbegriff des Hauptanspruches.

Zur Messung des Verhaltens eines Übertragungskanals bezüglich nichtlinearer Amplitudenverzerrungen kann die Amplitudenverteilung eines zu übertragenden Meßsignals genutzt werden, dessen Amplitudenverteilung theoretisch bekannt ist. Abweichungen von dieser idealen Amplitudenverteilung können so auf den Einfluß des Übertragungskanals zurückgeführt werden. Auf diese Weise können beispielsweise begrenzende Leistungsendstufen von Hochfrequenzsendern und dergleichen bezüglich nichtlinearer Amplitudenverzerrungen gemessen werden.

In Mueller K., et al.: "Application of Amplitude Histograms for Quality of Service Measurements of Optical Channels and Fault Identification", Proceedings of the European Conference on Optical Communication, 1998 ist ein Verfahren zur Messung und Beurteilung von optischen Übertragungskanälen beschrieben. Ausgehend von einer genügenden Anzahl (500000) von Abtastwerten oder Samples des optischen Signales werden Histogramme berechnet, sowie visuell und statistisch ausgewertet. Dabei umfasst die statistische Auswertung die Anpassung zweier Gaußfunktionen nach dem minimale-quadratische Fehler Prinzip und eine darauf basierende Bestimmung von Mittelwert und Varianz der gefundenen Gaußfunktionen. Aus den so gewonnenen statistischen Kennwerten wird ein Schätzwert für den sogenannten Q-Faktor berechnet.

In Takara S.H., et al.: "Optical Signal Quality Monitoring Method Based on Optical Sampling", Electronic Letters, GB, IEE Stevenage, Bd. 34, Nr. 22, 1998, Seiten 2152-2154 ist ein Verfahren zum Monitoring des sogenannten Q-Faktors beschrieben. Dieser gibt Auskunft über die Separierbarkeit der 'mark' (1) und 'space' (0) Signale bei optischen Übertragungskanälen. Die Messung beruht dabei auf der Auswertung eines Signal- oder Amplitudenhistograms mit Hilfe von Grenzwerten oder Thresholds. Dabei wird der Q-Faktor aus spezifischen Mittelwerten und Varianzen der so modifizierten Histogramme berechnet.

Die WO 99/17463 A2 beschreibt eine Methode zur Empfangssignalstärkemessung in Mobiltelefonen. Dabei wird die Tatsache genutzt, dass logarithmierte Vielfache der Energie als Summe auf einer linearen Achse aufgetragen werden können. Durch aufeinanderfolgende Zusammenfassung solcher Vielfacher kann in eine 1-bit Darstellung übergegangen werden, wodurch ein speicher- und batterieoptimales Verfahren im Handheldbetrieb erreicht wird.

Aufgabe der Erfindung ist es, eine besonders übersichtliche und für den Benutzer vorteilhafte Anzeige des Meßergebnisses einer solchen Messung der Amplitudenverteilung aufzuzeigen.

Diese Aufgabe wird ausgehend von einem Verfahren laut Oberbegriff des Hauptanspruches durch dessen kennzeichnende Merkmale gelöst. Vorteilhafte Weiterbildungen ergeben sich aus den Unteransprüchen.

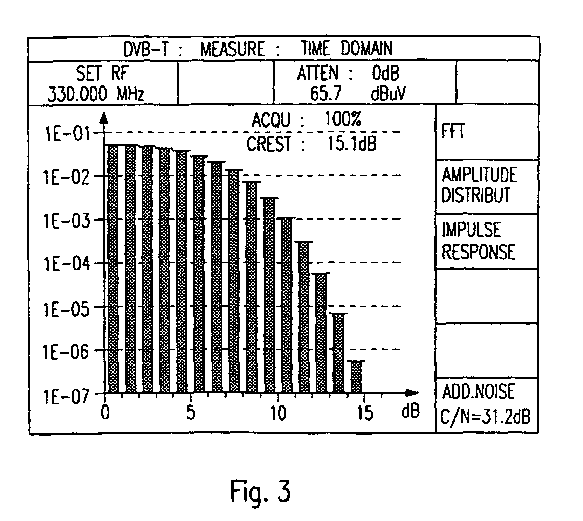

Durch die erfindungsgemäße Auswertung der Häufigkeitsverteilung der aufeinanderfolgend gemessenen Vielzahl von Amplitudenmeßwerten unter gleichzeitiger entsprechender Datenreduktion und Anzeige der Häufigkeitsverteilung in zu Amplitudenfenstern zusammengefaßten Häufigkeitswerten wird eine für den Benutzer eines entsprechenden Meßempfängers besonders übersichtliche und schnell auswertbare Anzeige geschaffen, wie dies Figur 3 zeigt.

Das erfindungsgemäße Verfahren wird nachfolgend anhand schematischer Zeichnungen näher erläutert.

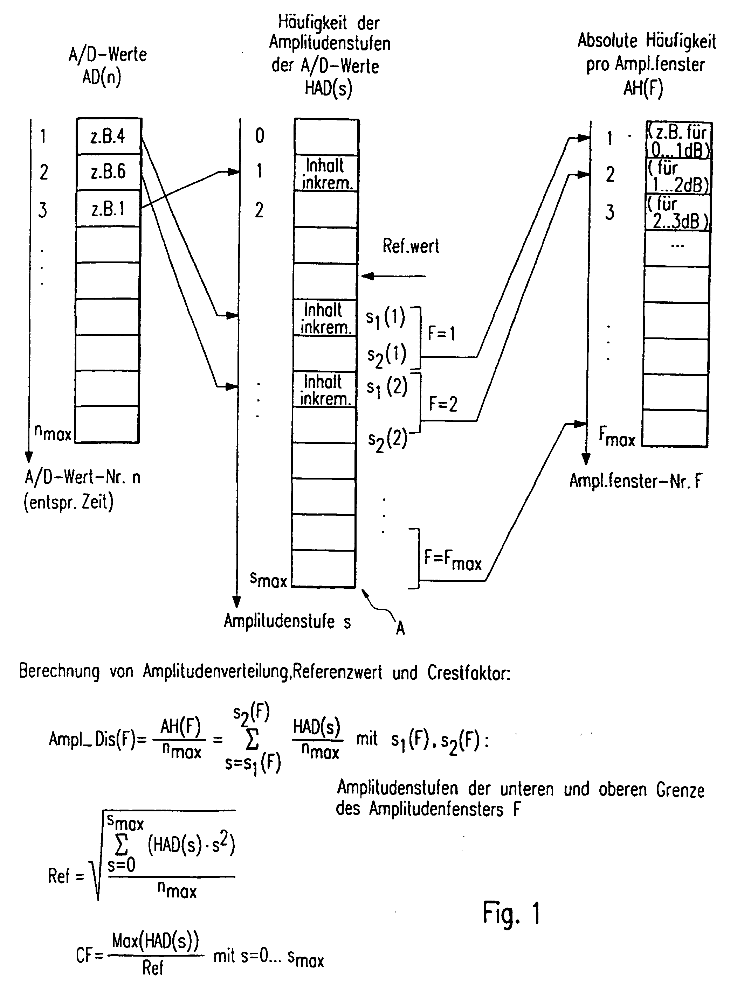

Die von einem Meßempfänger beispielsweise am Ausgang einer zu vermessenden Senderendstufe gemessenen aufeinanderfolgenden Amplitudenmeßwerte werden über einen A/D-Wandler digitalisiert und als aufeinanderfolgende Digitalwerte über einen Prozessor gemäß Figur 1 weiterverarbeitet. Für eine erste Darstellung wird eine vorbestimmte Anzahl nₘₐₓ von Digitalwerten, die einer vorbestimmten Meßzeit entsprechen, ausgewertet, in der Praxis beispielsweise 100000 aufeinanderfolgende Meßwerte. Diese aufeinanderfolgenden Meßwerte werden nun nach Häufigkeit sortiert, dazu wird für jeden Meßwert AD (n) gemäß Figur 1 jeweils diejenige Speicherzelle des Speichers A von sₘₐₓ + 1 Speicherzellen inkrementiert, deren Adresse dem Amplitudenwert des jeweils ausgewerteten Meßwertes entspricht. (theoretisch mögliche Amplitudenwerte: 0 bis sₘₐₓ).In dem Beispiel nach Figur 1 werden beispielsweise nacheinander die Amplitudenwerte 4,6,1, also jeweils ganze Zahlenwerte, gemessen. Wie durch die eingezeichneten Pfeile angedeutet, wird deren Häufigkeit in den zugehörigen Speicherzellen s = 0 bis sₘₐₓ gezählt, am Ende nach der Auswertung aller nₘₐₓ Amplitudenwerte ist also im Speicher A deren Häufigkeitsverteilung abgespeichert. In der Praxis besitzt der Speicher A beispielsweise 1024 aufeinanderfolgende Speicherzellen.

Anschließend wird aus diesen abgespeicherten Häufigkeitswerten ein Referenzwert, beispielsweise der Effektivwert, berechnet, der bei der endgültigen Anzeige als Bezugswert dient. Für eine logarithmische Anzeigeskala ist der Effektivwert am geeignetsten. Die Berechnung des Referenzwertes Ref erfolgt über die in Figur 1 angegebene Formel aus der Summe der Amplitudenhäufigkeit HAD, der Anzahl der Amplitudenstufen sₘₐₓ + 1 des Speichers A sowie der ausgewerteten Anzahl nₘₐₓ von Amplitudenwerten.

Zur noch weiteren Vereinfachung der Anzeige der Amplitudenverteilung des gemessenen Ausgangssignals werden die Amplitudenhäufigkeitswerte des Speichers A oberhalb des Referenzwertes Ref jeweils zu sogenannten Amplitudenfenstern F = 1 bis Fₘₐₓ zusammengefaßt und addiert. Die unteren und oberen Grenzen der Amplitudenfenster F sind jeweils mit s₁ bzw. s₂ bezeichnet. Bei Fenstergrenzen, die nicht genau die Mitte zwischen zwei Amplitudenstufen der vom A/D-Wandler zugeführten Meßwerte treffen, muß zur Erhöhung der Genauigkeit des Ergebnisses der Wert der Häufigkeit der betroffenen Amplitudenstufe gewichtet auf zwei Fenster verteilt werden. Durch diese Zusammenfassung von Häufigkeitswerten wird schließlich die absolute Häufigkeit AH (F) pro Amplitudenfenster F gewonnen und angezeigt. In dem dargestellten Beispiel nach Figur 1 sind oberhalb des als Effektivwert berechneten Referenzwertes von 0 dB beispielsweise 20 aneinander anschließende Amplitudenfenster F vorgesehen, wobei dem ersten Fenster der Bereich 0 bis 1 dB, dem zweiten Fenster 1 bis 2 dB, dem dritten Fenster 2 bis 3 dB usw. zugeordnet ist.

Figur 3 zeigt die davon abgeleitete Anzeige auf einem Bildschirm bzw. durch Ausdruck mittels eines Druckers. In horizontaler Richtung sind die 1-dB-Amplitudenfenster F aufgetragen, in vertikaler Richtung als Balken die Amplitudenverteilung, d.h. die Anzahl von Meßwerten in dem jeweiligen Amplitudenfenster, bezogen auf die insgesamt erfaßte Zahl von Meßwerten. 1E-2 heißt z.B., daß sich 10⁻², also 1% aller Meßwerte, innerhalb dieses 1-dB-Fensters befinden.

Aus der größten tatsächlich vorkommenden Amplitudenstufe s des Speichers A und dem als Effektivwert berechneten Referenzwert Ref kann auf einfache Weise auch der Crest-Faktor berechnet und angezeigt werden, dessen Berechnungsformel in Figur 1 angegeben ist.

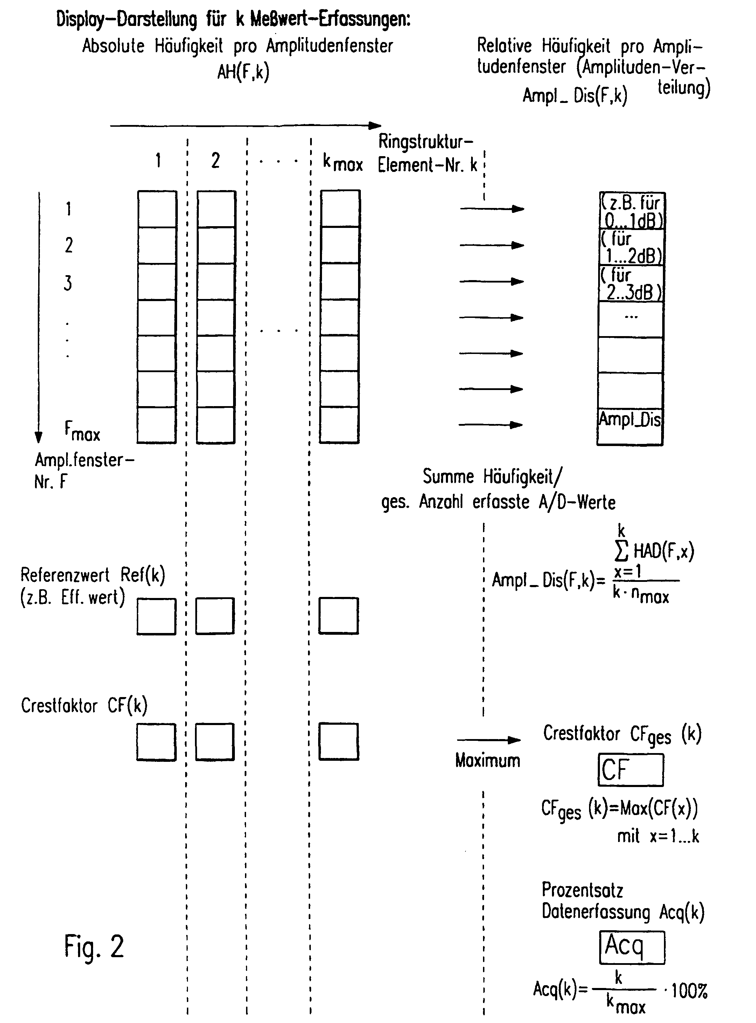

Für eine statistisch gesicherte Aussage über die tatsächliche Amplitudenverteilung ist eine bestimmte Anzahl z von Meßwerten AD (n) erforderlich. In manchen Fällen reicht hierfür die angegebene Vielzahl nₘₐₓ nicht aus, es müssen also kₘₐₓ = z/nₘₐₓ Meßwerte erfaßt werden, um die geforderte Meßgenauigkeit zu erreichen. Dazu wird gemäß Figur 2 eine Ringspeicherstruktur der Länge kₘₐₓ benutzt. Zunächst wird für eine erste Vielzahl nₘₐₓ von Meßwerten nach dem Aufbereitungsschema gemäß Figur 1 die entsprechende absolute Häufigkeit AH (F) pro Amplitudenfenster F ermittelt und in die erste Speicherzellenreihe k = 1 der Ringstruktur eingegeben und zwar zusammen mit dem ebenfalls nach Figur 1 berechneten Referenzwert und auch zusammen mit dem Crest-Faktor. Anschließend wird für die zweite Vielzahl nₘₐₓ von Meßwerten wieder nach dem Schema nach Figur 1 die absolute Häufigkeit pro Amplitudenfenster ermittelt und in die zweite Speicherzellenreihe k = 2 eingegeben usw., bis die gesamte Ringstruktur mit kₘₐₓ Elementen voll beschrieben ist. Nach jedem Eintrag in eine Speicherzellenreihe k erfolgt die Darstellung der Messung am Display, unter Berücksichtigung der bis jetzt verarbeiteten Meßwerte. Nach Eintragung in kₘₐₓ wird wieder die erste Reihe k = 1 der Ringstruktur überschrieben, so daß stets nur die aktuellsten Meßwerte verarbeitet werden. Aus den so in der Ringstruktur abgespeicherten absoluten Häufigkeitswerten wird die Summenhäufigkeit pro Amplitudenfenster berechnet und daraus schließlich die relative Häufigkeit pro Amplitudenfenster, die dann schließlich gemäß Figur 3 zur Anzeige kommt. Die Ringstruktur kann beispielsweise aus k = 100 einzelnen Speicherzellenreihen bestehen. Die relative Amplitudenhäufigkeit pro Amplitudenfenster, die schließlich gemäß Figur 3 angezeigt wird, errechnet sich dabei aus der aufaddierten absoluten Amplitudenhäufigkeit pro Amplitudenfenster dividiert durch die Anzahl der bisher aufgetretenen Meßwerte, wie dies durch die Formeln nach Figur 2 angegeben ist.

Auch der Crest-Faktor kann aus dem Maximum der bisher berechneten Crest-Faktoren ermittelt und angezeigt werden, wie dies ebenfalls durch die Formel in Figur 2 angegeben ist.

Schließlich kann noch der aktuelle Prozentsatz der für eine statistisch gesicherte Aussage insgesamt nötigen Anzahl von aufgenommenen Meßwerten angezeigt werden, er entspricht der Anzahl der gegenwärtig vorhandenen Eintragungen k in der Ringstruktur dividiert durch kₘₐₓ nach der ebenfalls in Figur 2 angegebenen Formel.

Zum Vergleich der gemessenen Amplitudenverteilung, wie sie in Figur 3 durch die vertikalen Balken dargestellt ist, mit der theoretisch vorgegebenen bekannten Amplitudenverteilung des benutzten Meßsignales können letztere zusätzlich noch in das Anzeigebild mit eingeblendet werden, wie dies in Figur 3 durch die horizontalen kurzen Striche je Amplitudenfenster angedeutet ist.

Als Meßsignal ist jedes Signal mit bekannter Amplitudenverteilung geeignet, vorzugsweise wird ein solches Signal benutzt, das auch im Betrieb über den zu messenden Übertragungskanal übertragen wird, beispielsweise ein nach dem DVB-T-Standard aufbereitetes digitales Fernsehsignal.

## Patentansprüche

1. Verfahren zum Anzeigen der Amplitudenverzerrungen eines Übertragungskanals,
wobei ein Meßsignal von bekannter Amplitudenverteilung über den Übertragungskanal übertragen wird,
wobei am Ausgang des Übertragungskanals die Amplitudenwerte gemessen werden,
wobei diese aufeinanderfolgenden Amplituden-Meßwerte in Digitalwerte umgewandelt werden,
wobei der Amplitudenwerte-Meßbereich in aneinander anschließende Amplitudenfenstern unterteilt wird,
wobei von einer vorgegebenen Vielzahl der aufeinanderfolgend gebildeten Amplituden-Digitalwerte die Häufigkeit ihres Auftretens in den aneinander anschließenden Amplitudenfenster bestimmt wird,
wobei die so ermittelten Amplitudenhäufigkeitswerte pro Amplitudenfenster mittels einer Anzeigeeinrichtung angezeigt werden,
wobei aus den insgesamt ermittelten Amplitudenhäufigkeitswerten ein Referenzwert ermittelt wird und nur die oberhalb dieses Referenzwertes auftretenden Amplitudenhäufigkeitswerte in Amplitudenfenstern angezeigt werden,
**dadurch gekennzeichnet,**
**daß** aus der Summe der Amplitudenhäufigkeitswerte der quadratisch gewichtete Mittelwert (Effektivwert) als Referenzwert berechnet wird.

2. Verfahren nach Anspruch 1,
**dadurch gekennzeichnet,**
**daß** zunächst die Häufigkeit des Auftretens der jeweils unterschiedlichen ganzzahligen Amplitudenmeßwerte der vorgegebenen Vielzahl bestimmt wird,
dann der Referenzwert berechnet wird und die oberhalb dieses Referenzwertes bestimmten Amplitudenhäufigkeitswerte jeweils zu Gruppen zusammengefaßt und addiert werden,
und diese Summen der jeweils zusammengefaßten Gruppen von Amplitudenhäufigkeitswerten in den aneinander anschließenden Amplitudenfenstern angezeigt werden.

3. Verfahren nach einem der vorhergehenden Ansprüche,
**dadurch gekennzeichnet,**
**daß** aus dem ermittelten größten Amplitudenhäufigkeitswert und dem Referenzwert der Crest-Faktor berechnet wird.

4. Verfahren nach einem der vorhergehenden Ansprüche,
**dadurch gekennzeichnet,**
**daß** für mehrere aufeinanderfolgende vorgegebene Vielzahlen nₘₐₓ von Amplitudenmeßwerten jeweils gemäß Anspruch 1 die Amplitudenhäufigkeit je Amplitudenfenster und daraus die Summenhäufigkeit ermittelt wird und dann die relative Amplitudenhäufigkeit pro Amplitudenfenster berechnet und angezeigt wird.

5. Verfahren nach Anspruch 3 oder 4,
**dadurch gekennzeichnet,**
**daß** auch der Crest-Faktor für mehrere aufeinanderfolgende vorgegebene Vielzahlen von Amplitudenmeßwerten bestimmt wird und über die daraus ermittelte Summenhäufigkeit der relative Crest-Faktor berechnet und angezeigt wird.

6. Verfahren nach einem der vorhergehenden Ansprüche,
**dadurch gekennzeichnet,**
**daß** in den Amplitudenfenstern gleichzeitig auch die ideale Amplitudenhäufigkeit des Meßsignals angezeigt wird.

7. Verfahren nach einem der vorhergehenden Ansprüche,
**dadurch gekennzeichnet,**
**daß** gleichzeitig auch der aktuelle Prozentsatz der momentan ausgewerteten Anzahl von vorgegebenen Vielzahlen angezeigt wird.

## Claims

1. Method for displaying the amplitude distortions of a transmission channel,
a measurement signal of known amplitude distribution being transmitted via the transmission channel,
the amplitude values being measured at the output of the transmission channel,
these successive amplitude measured values being converted into digital values,
the amplitude values measurement range being divided into adjacently connected amplitude windows, the frequency of occurrence of a given multitude of successively formed amplitude digital values being determined in the adjacently connected amplitude windows,
the amplitude frequency values thus determined for each amplitude window being displayed by means of a display device,
a reference value being determined from the amplitude frequency values determined as a whole and only the amplitude frequency values occurring above this reference value being displayed in amplitude windows,
**characterized in that**
the quadratically weighted average (root-mean-square value) is calculated from the sum of the amplitude frequency values as the reference value.

2. Method according to claim 1,
**characterized in that**
first the frequency of occurrence of the respectively different integer amplitude measured values of the given multitude is determined,
then the reference value is calculated and the amplitude frequency values determined above this reference value are combined and added respectively to form groups,
and these totals of the respectively combined groups of amplitude frequency values are displayed in the adjacently connected amplitude windows.

3. Method according to one of the preceding claims,
**characterized in that**
the crest factor is calculated from the greatest amplitude frequency value ascertained and from the reference value.

4. Method according to one of the preceding claims,
**characterized in that**
the amplitude frequency is ascertained for each amplitude window respectively according to claim 1 for several successive given multitudes nₘₐₓ of amplitude measured values and the cumulative frequency is ascertained therefrom and then the relative amplitude frequency for each amplitude window is calculated and displayed.

5. Method according to claim 3 or 4,
**characterized in that**
the crest factor is also determined for several successive given multitudes of amplitude measured values and the relative crest factor is calculated via the cumulative frequency ascertained therefrom and displayed.

6. Method according to one of the preceding claims,
**characterized in that**
the ideal amplitude frequency of the measurement signal is also displayed in the amplitude windows at the same time.

7. Method according to one of the preceding claims,
**characterized in that**
the current percentage of the momentarily evaluated number of given multitudes is also displayed at the same time.

## Revendications

1. Procédé d'affichage des distorsions d'amplitude d'un canal de transmission, où un signal de mesure d'une division d'amplitude connue est transmis par le canal de transmission, où les valeurs d'amplitude sont mesurées à la sortie du canal de transmission, où ces valeurs de mesure d'amplitude successives sont transformées en valeurs numériques, où la zone de mesure de valeurs d'amplitude est divisée en des fenêtres d'amplitude contigües, où à partir d'une pluralité prédéfinie de valeurs numériques d'amplitude formées successivement, la fréquence de leur apparition est déterminée dans les fenêtres d'amplitude qui se font suite, où les valeurs de fréquence d'amplitude ainsi déterminées par fenêtre d'amplitude sont affichées au moyen d'une installation d'affichage, où à partir des valeurs de fréquence d'amplitude déterminées au total, une valeur de référence est déterminée et seulement les valeurs de fréquence d'amplitude situées au-dessus de cette valeur de référence sont affichées dans des fenêtres d'amplitude,
**caractérisé en ce**
**qu'**à partir de la somme des valeurs de fréquence d'amplitude, la valeur moyenne pondérée quadratique (valeur effective) est calculée comme valeur de référence.

2. Procédé selon la revendication 1,
**caractérisé en ce que**
d'abord la fréquence de la survenue des valeurs de mesure d'amplitude différentes de nombres entiers de la pluralité prédéfinie est déterminée, qu'ensuite la valeur de référence est calculée, et que les valeurs de fréquence d'amplitude définies au-dessus de cette valeur de référence sont réunies respectivement en groupes et sont additionnées, et **en ce que** les sommes des groupes de valeurs de fréquence d'amplitude respectivement réunies sont affichées dans les fenêtres d'amplitude contigües.

3. Procédé selon l'une des revendications précédentes,
**caractérisé en ce que**
le facteur de crête est calculé à partir de la valeur de fréquence d'amplitude la plus grande déterminée et de la valeur de référence.

4. Procédé selon l'une des revendications précédentes,
**caractérisé en ce que**
pour plusieurs pluralités prédéfinies successives nₘₐₓ de valeurs de mesure d'amplitude respectivement selon la revendication 1, la fréquence d'amplitude par fenêtre d'amplitude et, à partir de celle-ci, la fréquence des sommes est déterminée et ensuite, la fréquence d'amplitude relative par fenêtre d'amplitude est calculée et affichée.

5. Procédé selon la revendication 3 ou 4,
**caractérisé en ce qu'**
aussi le facteur de crête est défini pour plusieurs pluralités prédéfinies sucessives de valeurs de mesure d'amplitude, et par la fréquence des sommes ainsi déterminée, le facteur de crête relatif est calculé et affiché.

6. Procédé selon l'une des revendications précédentes,
**caractérisé en ce que**
dans les fenêtres d'amplitude, en même temps également la fréquence d'amplitude idéale du signal de mesure est affichée.

7. Procédé selon l'une des revendications précédentes,
**caractérisé en ce qu'**
en même temps également le taux en pour cent actuel du nombre évalué momentanément de pluralités prédéfinies est affiché.
